# EUROPÄISCHE PATENTANMELDUNG

(11) **EP 2 533 303 A2**
(43) Veröffentlichungstag der Anmeldung: **12.12.2012**
(21) Anmeldenummer: 12163541.1
(22) Anmeldetag: 10.04.2012
(51) Int. Cl.: H01L 31/05

(54) **Solarmodul und Photovoltaik-Anlage**

(30) Priorität: 08.06.2011 DE 102011077224
(71) Anmelder: ROBERT BOSCH GMBH, 70442 Stuttgart (DE)
(72) Erfinder: Buettner, Thomas, 07745 Jena (DE)

(57) **Zusammenfassung**

Solarmodul, mit einer Mehrzahl von zu einem Strang verschalteten Solarzellen und von außen zugänglichen Strang-Anschlüssen, wobei in das Solarmodul eine Bypassleitung mit je einem von außen zugänglichen Bypass-Anschluss an ihren beiden Enden integriert ist.

## Beschreibung

Die Erfindung betrifft ein Solarmodul mit einer Mehrzahl von zu einem Strang verschalteten Solarzellen und von außen zugänglichen Strang-Anschlüssen. Des Weiteren betrifft sie eine Photovoltaik-Anlage, die eine Mehrzahl von Solarmodulen elektrisch miteinander verbunden umfasst.

### Stand der Technik

Photovoltaikmodule (PV-Module), vielfach auch Solarmodule genannt, beinhalten Solarzellen bzw. photoelektrisch aktive Schichten, welche Licht in elektrischen Strom wandeln. Diese besitzen Möglichkeiten zur elektrischen Kontaktierung, um die gewonnene elektrische Energie abzuführen bzw. um mehrere PV-Module zu einer größeren Anordnung zu verschalten. Dazu haben die PV-Module üblicherweise eine Anschlussdose.

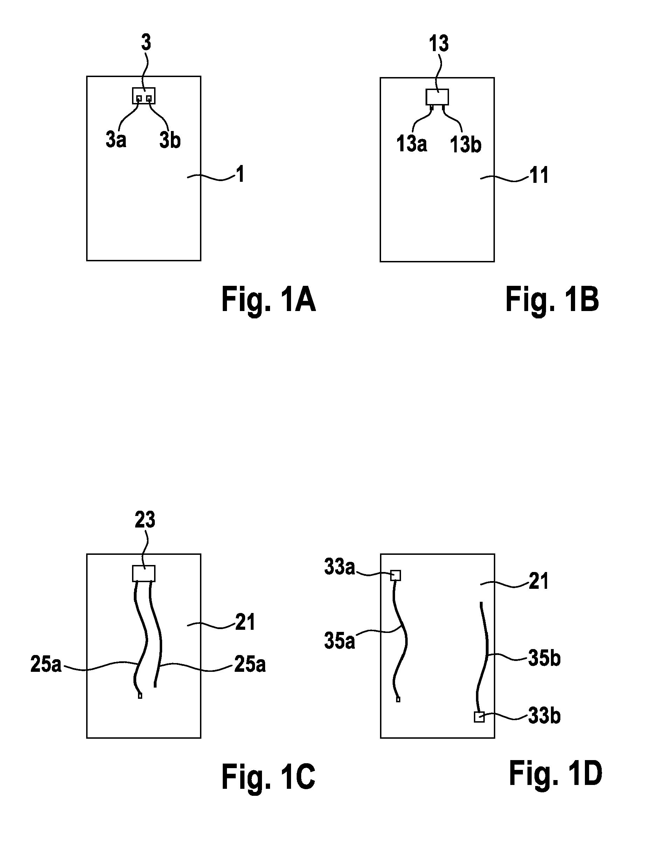

In Fig. 1A bis 1D sind verschiedene übliche Anschlussdosen- bzw. Kabel-Konfigurationen schematisch dargestellt. Fig. 1A zeigt schematisch eine Anschlussdose **3** mit zwei Anschlusskontakten **3a** und **3b** auf einem Solarmodul **1.** Fig. 1B zeigt skizzenhaft eine modifizierte Anschlussdose **13,** die zwei außen angebrachte Steckerteile bzw. Buchsen **13a, 13b** zum Anschluss von Stromleitungen aufweist, auf einem Solarmodul **11.** Fig. 1C zeigt ein Solarmodul **21** mit einer Anschlussdose **23,** mit der fest zwei Anschlusskabel **25a, 25b** verbunden sind, welche an ihrem jeweiligen Ende einen (nicht gesondert bezeichneten) Stecker bzw. eine Buchse haben. Fig. 1D schließlich zeigt ein Solarmodul **31** mit zwei Anschlussdosen **33a, 33b,** mit denen jeweils ein Anschlusskabel **35a, 35b** verbunden ist, welches an seinem Ende wiederum einen (nicht gesondert bezeichneten) Stecker bzw. eine Buchse trägt.

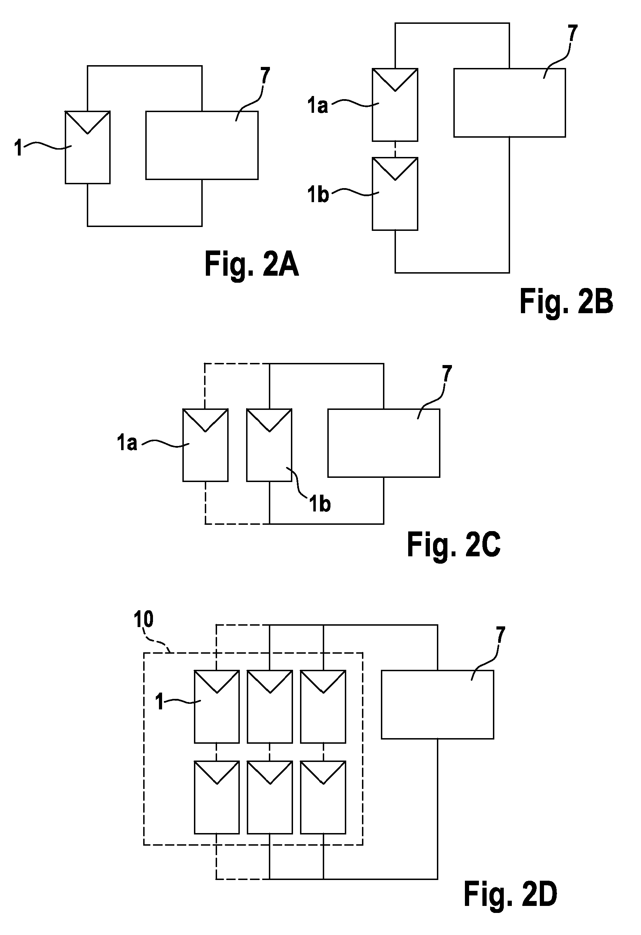

Die Fig. 2A bis 2D zeigen in Art von Blockschaltbildern verschiedene Möglichkeiten der Verschaltung von Solarmodulen mit einer Last, also einem Verbraucher oder Energiespeicher oder einer Netzeinspeisung. Fig. 2A zeigt die direkte Verschaltung eines einzelnen Solarmoduls **1** mit einer Last **7,** Fig. 2B die Serien schaltung zweier Solarmodule **1a** und **1b** mit einer Last **7,** Fig. 2C die Parallelschaltung zweier Solarmodule **1a** und **1b** mit einer Last **7** und Fig. 2D eine gemischte Serien- und Parallelschaltung von sechs Solarmodulen **1,** die zusammen eine Photovoltaik-Anlage **10** bilden, mit einer Last **7.**

### Offenbarung der Erfindung

Mit der Erfindung wird ein Solarmodul mit den Merkmalen des Anspruchs 1 sowie eine Photovoltaik-Anlage mit den Merkmalen des Anspruchs 5 bereitgestellt. Zweckmäßige Fortbildungen des Erfindungsgedankens sind Gegenstand der jeweiligen abhängigen Ansprüche.

In einer Ausführung der Erfindung ist vorgesehen, dass die Bypass-Anschlüsse und insbesondere auch die Strang-Anschlüsse als Steckkontakte ausgebildet sind. Hierbei können als Bypass-Anschlüsse ein männlicher und ein weiblicher Steckkontakt vorgesehen sein. Auch die Strang-Anschlüsse können als männlicher und weiblicher Steckkontakt vorgesehen sein.

In einer weiteren Ausführung weist die Bypassleitung einen band- oder drahtförmigen Leiter auf, der in eine Einhüllung, insbesondere eine Folien-Laminierung, des Solarmoduls mit eingehüllt ist.

In einer Photovoltaik-Anlage, die eine Mehrzahl von Solarmodulen nach einem der vorangehenden Ansprüche in Reihenschaltung umfasst, ist gemäß einem Aspekt der Erfindung die Reihenschaltung mit den miteinander verbundenen integrierten Bypassleitungen der Solarmodule als Rückleiter gebildet.

In einer Ausführungsform umfasst eine solche Anlage ein erstes Verbinderstück, welches zur elektrischen Verbindung eines Stranganschlusses mit einem Bypass-Anschluss ein und desselben Solarmoduls ausgebildet ist. In einer weiteren Ausführung umfasst die Anlage ein zweites Verbinderstück, welches zur elektrischen Verbindung je eines Bypass-Anschlusses zweier benachbart angeordneter Solarmodule ausgebildet ist. Bei diesen Ausgestaltungen sind das erste und/oder zweite Verbinderstück als im Wesentlichen starres Kunststoffteil mit einem eingebetteten Leiter und je einem an die Anschlüsse des Solarmoduls angepassten Verbinder-Anschluss an dessen Enden ausgebildet.

### Zeichnungen

Weitere Vorteile und vorteilhafte Ausgestaltungen der erfindungsgemäßen Gegenstände werden durch die Zeichnungen veranschaulicht und in der nachfolgenden Beschreibung erläutert. Dabei ist zu beachten, dass die Zeichnungen nur beschreibenden Charakter haben und nicht dazu gedacht sind, die Erfindung in irgendeiner Form einzuschränken. Es zeigen:
- Fig. 1A bis 1D: skizzenartige Darstellungen bekannter Anschlussmöglichkeiten von Solarmodulen über Anschlussdosen,
- Fig. 2A bis 2D: verschiedene praxisübliche Verschaltungsmöglichkeiten von Solarmodulen,
- Fig. 3A und 3B: schematische Darstellungen in Art von Schaltbildern zur Erläuterung der Erfindung bzw. einer Ausführungsform derselben,
- Fig. 4: eine perspektivische Darstellung eines Solarmoduls gemäß dieser Ausführung der Erfindung,
- Fig. 5: eine perspektivische Darstellung eines Verbinderstücks und des angrenzenden Bereichs eines Solarmoduls gemäß einer weiteren Ausführung der Erfindung,
- Fig. 6: eine schematische Darstellung zur Erläuterung der Funktion dieses Verbinderstücks,
- Fig. 7: eine perspektivische Darstellung eines Verbinderstücks und des angrenzenden Bereichs eines Solarmoduls gemäß einer weiteren Ausführung der Erfindung,
- Fig. 8: eine schematische Darstellung zur Erläuterung der Funktion dieses Verbinderstücks,
- Fig. 9: eine perspektivische Darstellung der benachbarten Kantenbereiche zweier in einer Serienschaltung bei einem Indachsystem zu verschaltender Solarmodule mit einem Verbindungsprofil und
- Fig. 10: eine schematische Darstellung zur Erläuterung des Aufbaus einer weiteren Photovoltaik-Anlage.

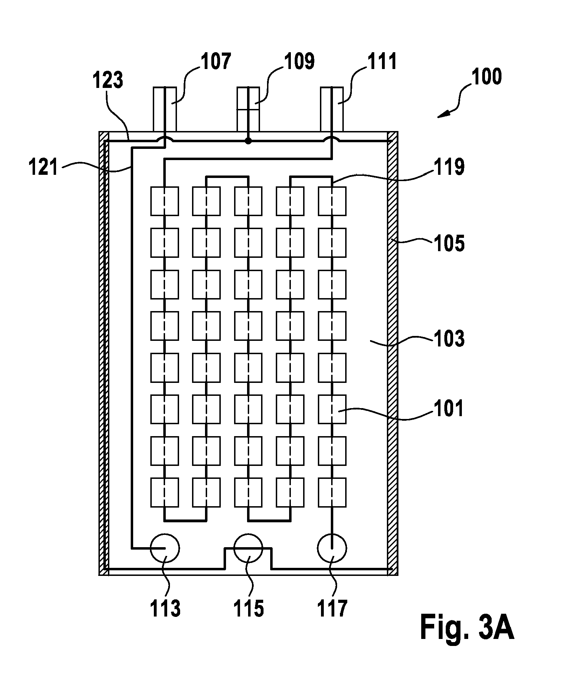

Fig. 3A zeigt schematisch, in Art einer Draufsicht, ein Solarmodul **100,** das eine Mehrzahl von Solarzellen **101** auf einem Substrat **103** aufweist und zwei leitfähige Rahmenprofile **105** hat. An einer der beiden kurzen Kanten des Solarmoduls **100** sind nebeneinander drei Stecker **107** bis **111** vorgesehen, und zwar ein Bypass-Stecker **107,** ein Erde-Stecker **109** und ein Pluspol-Stecker **111.** An der gegenüberliegenden kurzen Kante des Solarmoduls sind, in geometrisch korrespondierender Anordnung zu den erwähnten Steckern, drei Steckerbuchsen **113** bis **117** angeordnet, und zwar eine Bypass-Buchse **113,** eine Erdungskontakt-Buchse **115** und eine Minuspol-Buchse **117.** Über einen ersten Leiterzug **119** sind die Solarzellen **101** miteinander verschaltet und (über die Solarzellen) der Pluspol-Stecker **111** mit der Minuspol-Buchse **117** verbunden. Ein zweiter Leitungszug **121** verbindet direkt den Bypass-Stecker **107** mit der Bypass-Buchse **113,** und ein dritter Leitungszug **123** stellt eine Erdungsleitung dar, die unter Einbeziehung der leitfähigen Rahmenprofile **105** den Erdungsstecker **109** mit der Erdungskontakt-Buchse **115** verbindet.

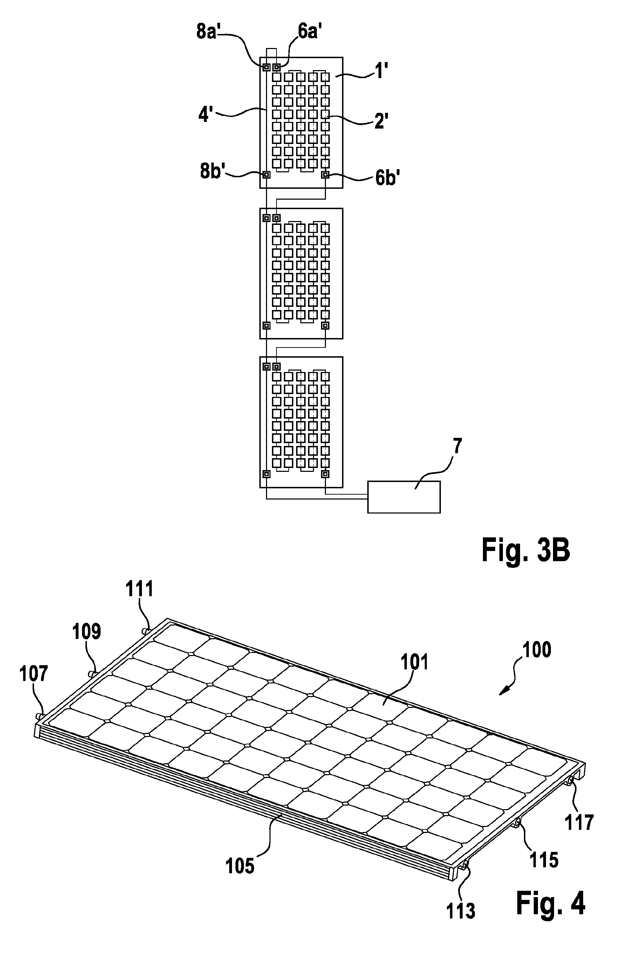

Fig. 3B zeigt schematisch eine Serienverschaltung von Solarmodulen **1',** die den oben beschriebenen Aufbau haben oder auch von diesem abweichen können, aber jedenfalls jeweils ein Array von zu einem Strang verschalteten Solarzellen **2'** und einen hiervon getrennten Bypass-Leiter **4'** umfassen. Den Solarzellen-Strängen sind jeweils ein erster und zweiter Anschlusskontakt **6a'** und **6b'** zugeordnet, und die Bypassleitung hat ebenfalls zwei Anschlusskontakte **8a'** und **8b'.** Die geeignete direkte Verbindung der Bypass-Kontakte, wie in der Figur schematisch dargestellt und weiter unten unter Bezugnahme auf spezielle Verbinderstücke genauer beschrieben, realisiert verkabelungs-frei einen durchgehenden Rückleiter und damit in besonders einfacher und zuverlässiger Weise die gewünschte Serienverschaltung mit der Last **7.**

Fig. 4 zeigt eine konstruktive Ausführung der Solarzelle **100** in perspektivischer Darstellung, in der die gleichen Bezugsziffern wie bei Fig. 3A zur Bezeichnung der wesentlichen Teile genutzt sind, die Leiterzüge **119** bis **123** jedoch nicht erkennbar sind.

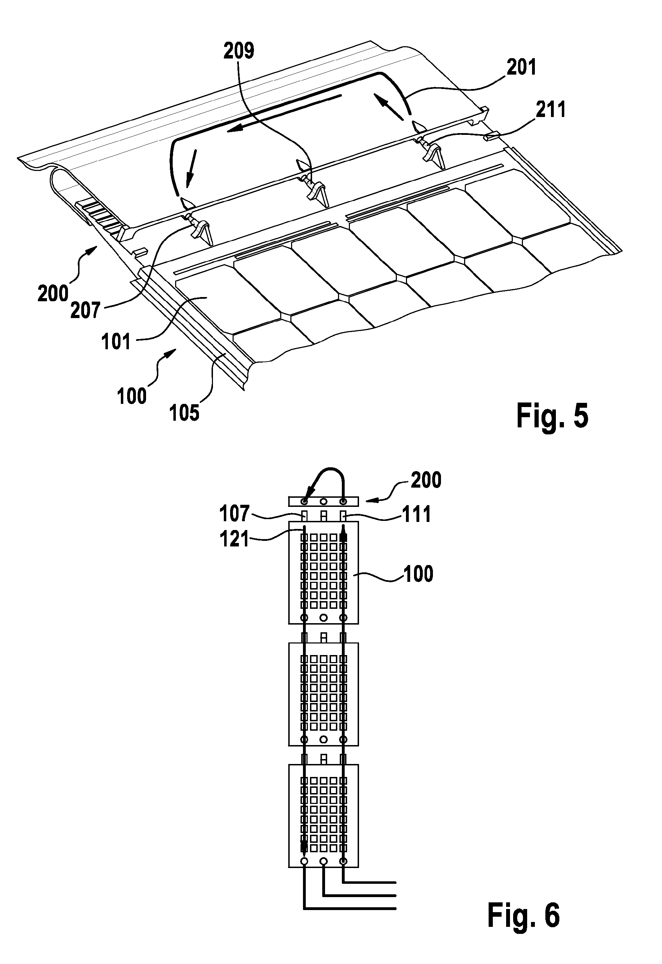

Fig. 5 zeigt in einer perspektivischen Detaildarstellung den Bereich einer kurzen Kante des Solarmoduls **100** mit einem an diese angesetzten Verbinderstück **200,** auf dem drei Steckerteile angeordnet sind, die in Anlehnung an die Wahl der Bezugsziffern in Fig. 3 hier mit den Ziffern **207, 209** und **211** bezeichnet sind. Zwischen den äußeren Steckerteilen **207** und **211,** also einem Bypass-Steckerteil und Pluspol-Steckerteil, ist ein Verbindungskabel **201** verlegt, welches an seinen Enden zu den Steckern passende (nicht gesondert bezeichnete) Buchsen trägt. Die Figur zeigt auch ein auf das Verbinderstück **200** aufgesetztes weiteres Kunststoffteil, welches in der Figur jedoch nicht bezeichnet ist und hier nicht weiter erläutert wird, weil es nicht zur vorliegenden Erfindung gehört.

Fig. 6 zeigt schematisch die Funktion des Verbinderstücks **200** in einer Serienschaltung von drei Solarmodulen **100** als oberes Abschlussstück, nämlich die Realisierung der Serienverschaltung über die Verbindung des Pluspols des obersten Solarmoduls mit dessen integrierter Bypassleitung **121.**

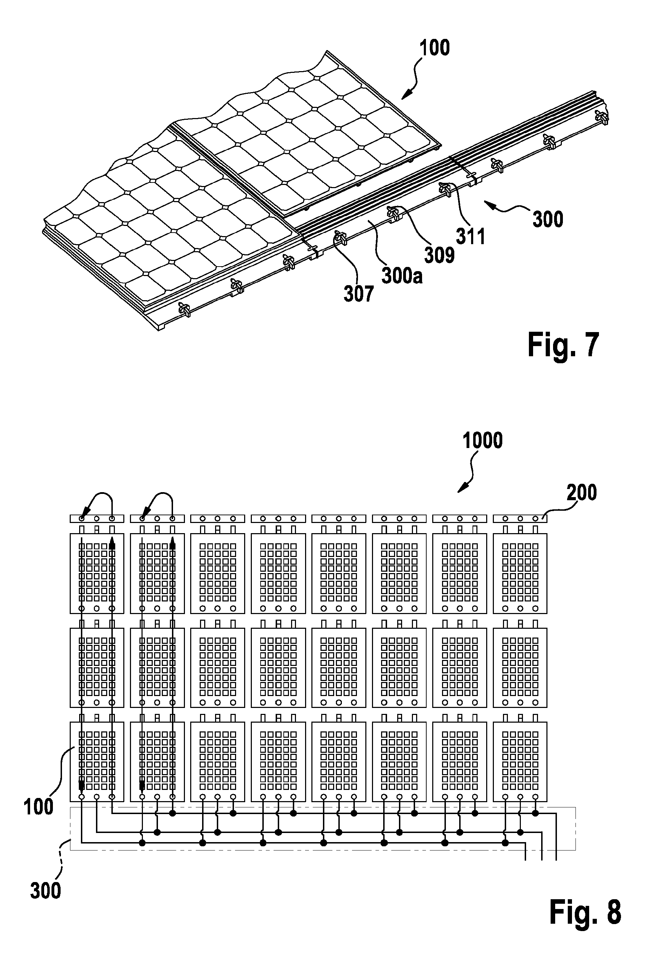

Fig. 7 zeigt in perspektivischer Darstellung die (unteren) kurzen Seiten zweier Solarmodule **100,** die in einer Photovoltaik-Anlage parallel miteinander zu verschalten sind, zusammen mit einem Verbinderstück **300,** welches als langgestrecktes Profil aus mehreren Teilabschnitten **300a** zusammengesetzt ist, von denen jedes - ähnlich wie das in Fig. 5 gezeigte Profil **200 -** ein Bypass-Steckerteil **307,** ein Erdungskontakt-Steckerteil **309** und ein Pluspol-Steckerteil **311** umfasst. Diese Steckerteile sind zum Eingriff in die (aus Gründen der besseren Übersichtlichkeit hier nicht gesondert bezeichneten) Buchsen-Teile des Solarmoduls **100** positioniert und ausgebildet.

Fig. 8 zeigt schematisch die Platzierung und innere Leitungsführung des Verbinderstücks **300** in einer Photovoltaik-Anlage **1000** aus drei Reihen von jeweils acht parallel miteinander verschalteten Solarmodulen **100.** Die rechts unten eingezeichneten Ausgänge führen zum Wechselrichter der Anlage.

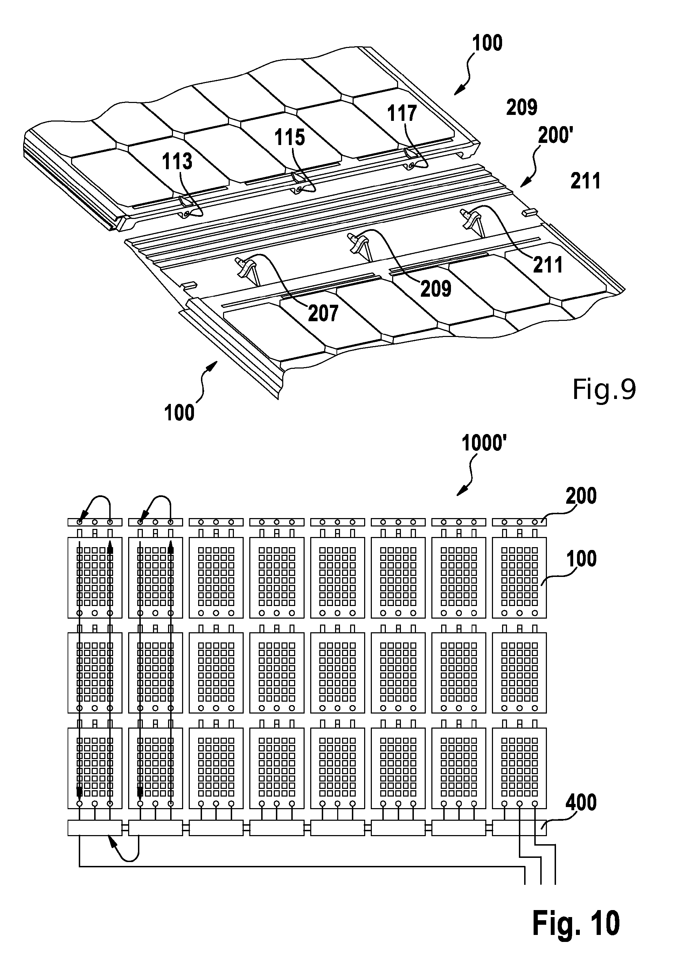

Fig. 9 zeigt, abermals in perspektivischer Detailansicht, die kurzen Seiten zweier in einer Serienschaltung miteinander zu verbindenden Solarmodule **100** zusammen mit einem gegenüber der in Fig. 5 gezeigten Ausführung modifizierten Verbinderstück **200',** welches sich vom Verbinderstück **200** durch den Fortfall des integrierten Verbindungskabels auszeichnet. Die Steckerteile **207, 209** und **211** greifen hier im montierten Zustand in die korrespondierend angeordneten und ausgeformten Buchsen-Teile **113, 115** und **117** des oberen Solarmoduls ein, wodurch letztlich der Pluspol des unteren Solarmoduls mit dem Minuspol des oberen und jeweikls die Erdungsanschlüsse beider Solarmodule und deren Bypass-Anschlüsse verbunden werden.

Fig. 10 schließlich zeigt schematisch eine Photovoltaik-Anlage **1000',** bei der sämtliche Solarmodule **100** in Reihe miteinander geschaltet sind, wobei Verbinderstücke **200** gemäß Fig. 5 und (hier nicht dargestellte) Verbinderstücke **200'** gemäß Fig. 9 neben zusätzlichen Verbinderstücken **400** eingesetzt werden können, die an der Unterkante der Anlage platziert sind und, ähnlich wie die Konfiguration nach Fig. 7, als Stromschienensystem konstruiert sein können.

Im Rahmen fachmännischen Handelns ergeben sich weitere Ausgestaltungen und Ausführungsformen des hier nur beispielhaft beschriebenen Verfahrens und der Vorrichtung.

## Patentansprüche

1. Solarmodul, mit einer Mehrzahl von zu einem Strang verschalteten Solarzellen und von außen zugänglichen Strang-Anschlüssen, wobei in das Solarmodul eine Bypassleitung mit je einem von außen zugänglichen Bypass-Anschluss an ihren beiden Enden integriert ist.

2. Solarmodul nach Anspruch 1,
wobei die Bypass-Anschlüsse und insbesondere auch die Strang-Anschlüsse als Steckkontakte ausgebildet sind.

3. Solarmodul nach Anspruch 2,
wobei als Bypass-Anschlüsse ein männlicher und ein weiblicher Steckkontakt vorgesehen sind.

4. Solarmodul nach einem der vorangehenden Ansprüche,
wobei die Bypassleitung einen band- oder drahtförmigen Leiter aufweist, der in eine Einhüllung, insbesondere eine Folien-Laminierung, des Solarmoduls mit eingehüllt ist.

5. Photovoltaik-Anlage, die eine Mehrzahl von Solarmodulen nach einem der vorangehenden Ansprüche in Reihenschaltung umfasst,
wobei die Reihenschaltung mit den miteinander verbundenen integrierten Bypassleitungen der Solarmodule als Rückleiter gebildet ist.

6. Photovoltaik-Anlage nach Anspruch 5, mit einem ersten Verbinderstück, welches zur elektrischen Verbindung eines Stranganschlusses mit einem Bypass-Anschluss ein und desselben Solarmoduls ausgebildet ist.

7. Photovoltaik-Anlage nach Anspruch 5 oder 6, mit einem zweiten Verbinderstück, welches zur elektrischen Verbindung je eines Bypass-Anschlusses zweier benachbart angeordneter Solarmodule ausgebildet ist.

8. Photovoltaik-Anlage nach Anspruch 6 oder 7,
wobei das erste und/oder zweite Verbinderstück als im Wesentlichen starres Kunststoffteil mit einem eingebetteten Leiter und je einem an die Anschlüsse des Solarmoduls angepassten Verbinder-Anschluss an dessen Enden ausgebildet ist.
